Europäisches Patentamt

European Patent Office

Office européen des brevets

(19)

(11) **EP 0 780 973 B1**

(12) **FASCICULE DE BREVET EUROPEEN**

(45) Date de publication et mention
de la délivrance du brevet:
**02.05.2003 Bulletin 2003/18**

(51) Int Cl.⁷: **H03H 7/01**

(21) Numéro de dépôt: **96402607.4**

(22) Date de dépôt: **02.12.1996**

(54) **Filtre réjecteur de bande à composants passifs**

Kerbfilter mit passiven Elementen

Notch filter with passive components

(84) Etats contractants désignés:
**BE DE GB NL**

(30) Priorité: **20.12.1995 FR 9515163**

(43) Date de publication de la demande:
**25.06.1997 Bulletin 1997/26**

(73) Titulaires:
• **FRANCE TELECOM**
**75015 Paris (FR)**
• **TELEDIFFUSION DE FRANCE**
**75015 Paris (FR)**

(72) Inventeurs:
• **Havot, Henri**
**35510 Cesson Sevigne (FR)**
• **Dutertre, Yvon**
**35690 Acigne (FR)**
• **Launay, Gilles**
**35830 Betton (FR)**
• **Leveque, Alain**
**35760 Saint-Gregoire (FR)**

(74) Mandataire: **Dubois-Chabert, Guy et al**
**BREVATOME**
**3, rue du Docteur Lanceraux**
**75008 Paris (FR)**

(56) Documents cités:
**US-A- 5 148 133** **US-A- 5 202 656**

• **CABLES ET TRANSMISSION, vol. 28, no. 3, Juillet 1974, PARIS FR, pages 181-203, XP002012761 COLIN, JEAN-EDOUARD: "Sur les filtres de synthèse a deux bandes passantes et a deux bandes coupèes"**
• **MICROWAVE JOURNAL, vol. 33, no. 9, 1 Septembre 1990, page 207, 208, 210, 212 XP000168024 HELKEY R: "A NEW RECEIVER FILTER TRANSFORMATION"**
• **SWANSON D: "THIN-FILM LUMPED-ELEMENT MICROWAVE FILTERS" 13 Juin 1989 , INTERNATIONAL MICROWAVE SYMPOSIUM, LONG BEACH, JUNE 13 - 15, 1989. VOLUMES 1 - 3 BOUND AS ONE, VOL. 1, PAGE(S) 671 - 674 , INSTITUTE OF ELECTRICAL AND ELECTRONICS ENGINEERS XP000077234 * le document en entier ***

**Description**

Domaine technique

La présente invention concerne un filtre réjecteur de bande à composants passifs.

Elle trouve des applications en électronique pour la réalisation de filtres réjecteurs de bande fonctionnant dans une gamme de fréquences allant de quelques mégahertz à quelques gigahertz.

L'invention peut être utilisée par exemple pour le filtrage de signaux reçus ou émis par une antenne.

Etat de la technique antérieure

Les filtres réjecteurs de bande connus comportent une ou plusieurs cellules de filtrage de type résonnant parallèle. Ces cellules sont constituées d'un élément capacitif et d'un élément inductif montés en parallèle et formant un circuit résonnant. Dans la suite du texte, pour des raisons de simplification on désigne respectivement les éléments capacitifs et les éléments inductifs par "capacité" et "inductance".

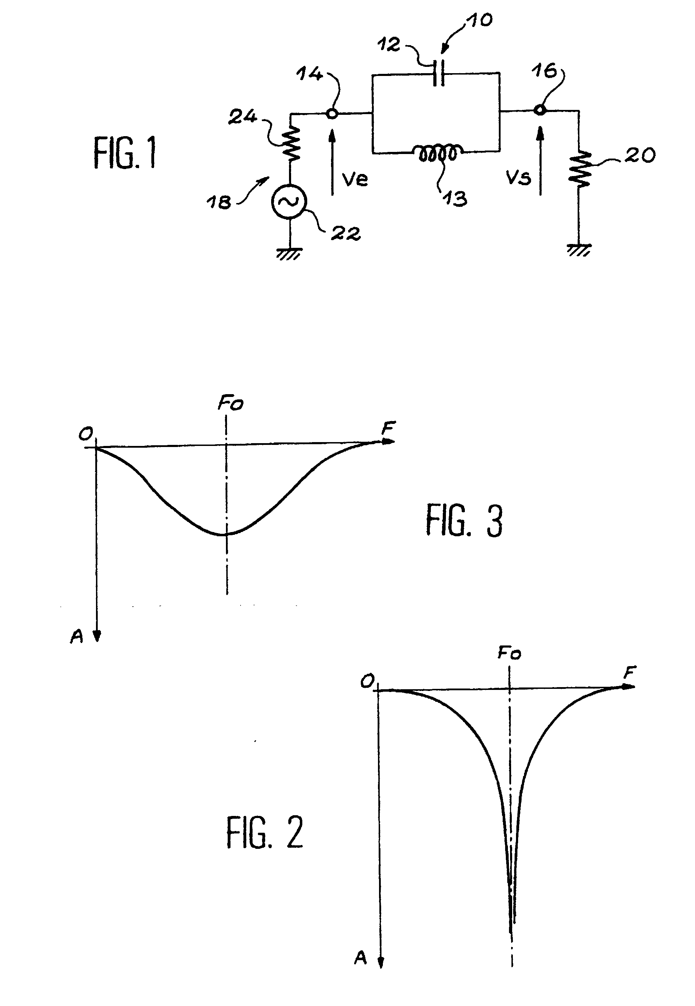

La figure 1 des dessins annexés montre un exemple de filtre réjecteur connu qui ne comporte qu'une seule cellule.

La cellule repérée par la référence générale 10 comprend une capacité telle qu'un condensateur 12 et une inductance, telle qu'une bobine 13, branchées en parallèle entre une borne d'entrée 14 et une borne de sortie 16 de la cellule.

On considère que le filtre qui comporte cette unique cellule fait partie d'une ligne de transmission pour transmettre un signal d'une source 18 vers une charge 20.

La source 18 est schématiquement représentée avec un générateur 22 et sa résistance interne 24. Les tensions d'entrée et de sortie, Ve et Vs, sont mesurées respectivement aux bornes 14 et 16 par rapport à la masse.

La fonction de transfert de ce filtre, qui peut être comprise comme l'expression du rapport $\frac{Vs}{Ve}$ en fonction de la fréquence du signal, présente un pôle pour une fréquence

$$f_o = \frac{1}{2\pi\sqrt{LC}}$$

qui est la fréquence de résonance de la cellule. De même, l'impédance $Z_A$ de la cellule, peut être exprimée en fonction de la pulsation $\omega$ par la formule suivante :

$$Z_A = \frac{jL\omega}{\left(1 - LC\omega^2\right)}$$

Dans les expressions de la fréquence $f_o$ et de l'impédance $Z_A$, L désigne la valeur de l'inductance, et C désigne la valeur de la capacité. Le terme j est défini tel que $j^2 = -1$.

La figure 2 représente la réponse théorique du filtre de la figure 1. Sur l'axe des ordonnées est portée l'atténuation A, c'est-à-dire le rapport Vs/Ve, comptée en décibels (les valeurs en décibels de ce rapport, inférieur à 1, sont négatives). L'axe des abscisses correspond à la fréquence F du signal. Les échelles de l'axe des abscisses et de l'axe des ordonnées sont arbitraires.

Il apparaît que, pour la fréquence de résonance, l'atténuation A est, en principe, infiniment grande.

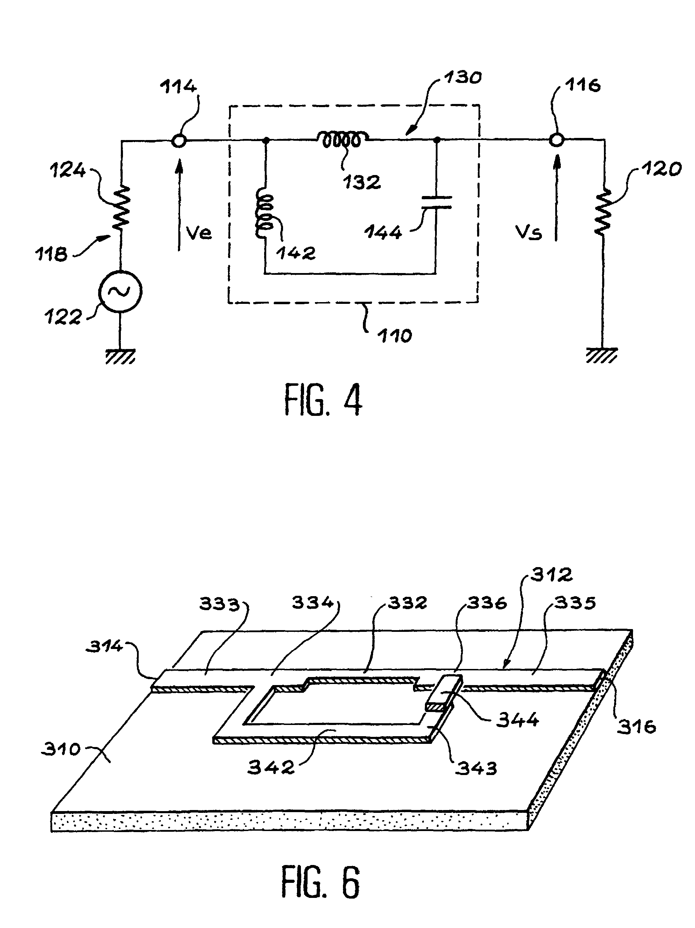

En réalité, les composants utilisés pour constituer une cellule de filtre ne sont pas parfaits. La bobine 13, en particulier, n'est pas une pure inductance mais possède une résistance qui est loin d'être négligeable. Il en résulte un amortissement qui a pour effet de modifier sensiblement la courbe d'atténuation. Celle-ci prend alors l'allure représentée sur la figure 3. Il existe toujours une fréquence où l'atténuation est maximale (en valeur absolue), mais cette atténuation a une valeur finie (par exemple 20 ou 30 dB). Elle peut se révéler insuffisante dans la pratique lorsqu'il s'agit d'obtenir une réjection efficace ou d'obtenir une coupure nette dans une bande de fréquences étroite.

Lorsque la valeur de l'impédance du filtre est voisine de zéro, le rapport $\frac{Vs}{Ve}$ est voisin de 1. La qualité du filtre est d'autant meilleure que la transition entre les régions où la valeur de l'impédance est voisine de zéro vers la région d'atténuation maximale est rapide.

Pour augmenter les performances des filtres, ceux-ci peuvent être constitués de plusieurs cellules telles que la cellule 10 de la figure 1. Ces cellules sont alors associées par exemple dans un montage avec une structure en $\Pi$.

Les filtres formés de plusieurs cellules comportent cependant un nombre plus important de composants et sont par conséquent d'un coût plus élevé.

Un but de la présente invention est de proposer un filtre réjecteur de bande à fréquence centrale de réjection unique qui présente une réjection dans une bande beaucoup plus étroite que les filtres connus, c'est-à-dire un filtre avec une meilleure sélectivité. Un autre but de l'invention est de proposer un filtre réjecteur avec une meilleure atténuation maximale.

Un but de l'invention est aussi de proposer un filtre d'un coût de fabrication très réduit, ne comprenant qu'un petit nombre de composants.

Un autre but encore est de proposer un filtre ne comportant pas de composants actifs et pouvant être réalisé, au moins en partie, sous la forme d'un circuit à microbandes.

Exposé de l'invention

Pour atteindre ces buts, l'invention a plus précisément pour objet un filtre réjecteur de bande à fréquence centrale de réjection unique, fonctionnant dans une gamme de fréquences allant de quelques mégahertz à quelques gigahertz et formé exclusivement d'une ou de plusieurs cellules de filtrage, chaque cellule étant composée exclusivement :

- dune première branche de circuit comportant une première inductance et reliant une borne d'entrée de la cellule à une borne de sortie de la cellule, et
- dune deuxième branche de circuit comportant en série une deuxième inductance et une capacité, cette deuxième branche étant connectée en parallèle sur la première inductance,

la première inductance ayant une valeur $\ell$ inférieure à la valeur L de la deuxième inductance, les valeurs $\ell$ et L étant telles que $\frac{L}{100} \leq \ell \leq \frac{L}{10}$.

Un tel filtre peut être réalisé avec un nombre très réduit de composants électroniques ; son coût de fabrication est donc faible.

Selon une réalisation particulière du filtre, la première branche peut comporter des lignes à microruban conducteur, disposées sur un substrat, et reliant respectivement la borne d'entrée de la cellule à une première extrémité de la première inductance et une deuxième extrémité de la première inductance à la borne de sortie de la cellule.

Les lignes à microruban peuvent être réalisées selon des techniques connues de mise en forme de circuits imprimés. Grâce au contrôle précis des dimensions des motifs formés selon ces techniques il est possible d'ajuster avec précision les paramètres d'impédance du filtre.

La première inductance, peut également être constituée par une portion de microruban conducteur. La longueur, non nulle, de cette portion est proportionnelle à la valeur de l'inductance recherchée.

Selon une réalisation particulière du filtre, celui-ci peut comporter un microruban qui forme l'ensemble de la première branche de circuit, c'est-à-dire à la fois les lignes à microruban et la première inductance.

Le filtre de l'invention peut comporter une cellule de filtre, ou éventuellement, une pluralité de cellules.

Dans ce dernier cas, celles-ci peuvent être reliées en chaîne, par exemple. Chaque cellule est reliée par sa borne d'entrée, soit à l'entrée du filtre, soit à la borne de sortie de la cellule précédente de la chaîne. De la même, la borne de sortie de chaque cellule est reliée soit à la sortie du filtre, soit à la borne d'entrée de la cellule suivante dans la chaîne.

D'autres caractéristiques et avantages de la présente invention ressortiront mieux de la description qui va suivre, en référence aux dessins annexés, donnée à titre purement illustratif et non limitatif.

Brève description des figures

- la figure 1, déjà décrite, représente un filtre réjecteur de bande d'un type connu,
- la figure 2, déjà décrite, représente la réponse en fréquence théorique d'un filtre conforme à la figure 1,
- la figure 3, déjà décrite, représente la réponse en fréquence réelle d'un filtre conforme à la figure 1,
- la figure 4 représente schématiquement un filtre à une cellule conforme à la présente invention,
- la figure 5 représente de façon comparative la réponse en fréquence du filtre de l'invention et d'un filtre connu,
- la figure 6 montre une réalisation pratique du filtre de la figure 3.

Description détaillée de modes de mise en oeuvre de l'invention

Comme pour la figure 1, on considère que le filtre représenté à la figure 4 fait partie d'une ligne de transmission d'un signal d'une source 118 vers une charge 120.

La source 118 comporte un générateur 122, avec une résistance interne propre 124.

Le filtre de la figure 4 comporte une seule cellule 110.

Conformément à l'invention, la cellule comprend une première branche de circuit 130 reliant une borne d'entrée 114 de la cellule à une borne de sortie 116. La branche 130 comporte une première inductance 132, par exemple sous la forme d'un fil conducteur bobiné. Elle présente une valeur d'inductance désignée par $\ell$.

La cellule comporte une deuxième branche 140 connectée en parallèle sur la première inductance 132.

La deuxième branche 140 est constituée d'une deuxième inductance 142 et d'une capacité 144 montées en série.

La deuxième inductance présente une valeur L comprise environ entre $10\ell$ et $100\ell$ ; la capacité présente une valeur C.

Les valeurs L et C sont ajustées notamment en fonction de la fréquence centrale de réjection souhaitée.

L'impédance de la cellule $Z_I$, en fonction de la pulsation $\omega$ peut être exprimée par l'expression suivante :

$$Z_I = j \frac{\ell\omega\left(LC\omega^2 - 1\right)}{(L + \ell)C\omega^2 - 1}$$

où $j^2=-1$.

La fréquence de résonance qui correspond à la fréquence de plus forte atténuation est égale à

$$f_o = \frac{1}{2\pi\sqrt{C(\ell + L)}}.$$

Comme la valeur de $\ell$ est faible devant L, la fréquence de plus forte atténuation est voisine de la fréquence de plus forte atténuation de la cellule de la figure 1.

Contrairement au filtre connu de la figure 1, le filtre de l'invention permet d'obtenir des bandes de réjection étroites avec des fortes valeurs d'inductance L et de faibles valeurs de capacité C.

Dans le filtre de la figure 1, correspondant à l'art antérieur, une possibilité pour obtenir une réjection plus sélective consistait à diminuer la valeur de l'inductance L. Ceci, pour une fréquence de réjection $f_o$ donnée, impliquait donc l'augmentation de la valeur de la capacité C. Or la valeur C est limitée par les problèmes de réalisation pratique.

A l'aide d'un exemple, on peut montrer que ces problèmes ne se posent pas dans le cas du filtre de l'invention.

Dans cet exemple on calcule l'impédance du filtre de l'art antérieur ($Z_A$) avec $L=10^{-2}$ et $C=10^2$ (en unités arbitraires), c'est-à-dire avec une faible valeur d'inductance. On calcule aussi l'impédance ($Z_I$) du filtre de l'invention avec $L=1$ et $C=1$, c'est-à-dire une valeur d'inductance cent fois supérieure.

On obtient

$$Z_A = j\,\frac{\omega}{1-\omega^2} \cdot 10^{-2}$$

(art antérieur)

$$Z_I = j\omega.10^{-2}$$

(invention)

On a à la résonance, c'est-à-dire lorsque $\omega=\omega_0=1$, $Z_I=Z_A(1-\omega^2)$. Pour une valeur de $\omega$ proche de $\omega_0$ telle que $\omega=\omega_0+\Delta\omega$ on a :

$$1-\omega^2 = 1-\omega_0^2 + 2\Delta\omega\omega_0 + \Delta\omega^2 \simeq 2\Delta\omega.$$

Or, $2\Delta\omega$ est très inférieur à l'unité. Pour des valeurs proches de la résonance on vérifie donc que $Z_I << Z_A$.

Ainsi, même pour des valeurs de L cent fois supérieures, le filtre de l'invention présente une meilleure réjection que le filtre de l'art antérieur.

La figure 5 permet également de comparer les caractéristiques d'un filtre conforme à l'invention, représenté à la figure 4, et d'un filtre selon l'art antérieur, tel que représenté à la figure 1.

Sur l'axe des ordonnées est représentée l'atténuation en décibels, selon une échelle arbitraire. Sur l'axe des abscisses sont reportées les fréquences dans une gamme allant de 550MHz à 952 MHz, et selon une échelle arbitraire.

La courbe 200 est la réponse d'un filtre connu conforme à la figure 1 réalisé avec des valeurs d'inductance et de capacité telles que L=15,8 nH et C=2,65 pF.

La courbe 202 est la réponse d'un filtre de l'invention conforme à la figure 4 réalisé avec les mêmes valeurs de L et de C et dans lequel on a choisi la valeur $\ell$ de la première inductance très faible par rapport à L.

On constate sur la figure que les pentes de la courbe 202 sont plus "raides" que celles de la courbe 200 et que la bande rejetée du filtre de l'invention est, par conséquent, plus étroite que celle du filtre de l'art antérieur.

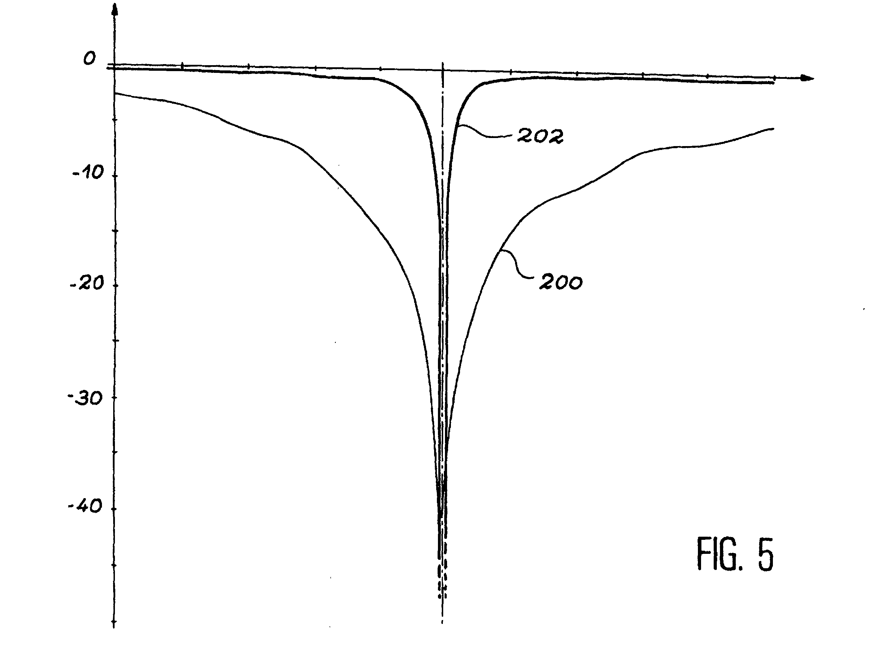

La figure 6 illustre une réalisation pratique d'un filtre conforme à l'invention.

Le filtre de la figure 6 est réalisé sur une plaquette isolante 310. Un microruban 312 gravé dans une couche de matériau conducteur recouvrant initialement toute la surface de la plaquette 310, forme la première branche du filtre. Une portion 332 du ruban 312 constitue la première inductance. La longueur de cette portion est proportionnelle à la valeur $\ell$ de la première inductance. A titre d'exemple pour $\ell=1$ nH la portion 332 peut présenter une longueur de 4,19 mm.

Des portions 333 et 335 du microruban 312 relient respectivement des extrémités 334, 336 de la portion 332 à l'entrée 314 et à la sortie 316 du filtre.

Un appendice 342 du microruban 312 est relié par l'une de ses extrémités à l'extrémité 334 de la portion 332 formant la première inductance.

L'appendice 342 forme la deuxième inductance, sa longueur, supérieure à la longueur de la portion de microruban 332 est proportionnelle à la valeur L de la deuxième inductance. A titre d'exemple, la longueur est de 19,2 mm pour une valeur L de 15,8 nH.

Une extrémité libre 343 de l'appendice 342 est reliée à l'extrémité 336 de la portion de ruban 332, par l'intermédiaire d'un condensateur 344. Le condensateur 344 peut être un composant monté en surface (CMS). La valeur C de la capacité est de 2,65 pF, par exemple.

Il apparaît immédiatement que la réalisation d'un filtre conforme à l'invention est particulièrement simple. Elle se résume à la mise en forme d'une couche conductrice pour réaliser le microruban conducteur et la mise en place du condensateur.

On peut noter sur la figure 6 que la partie du ruban 312 correspondant à la première branche de la cellule de filtre, c'est-à-dire la partie constituée des portions 332, 333 et 335 ne présente pas une largeur constante. En ajustant la largeur du ruban 312, ou la largeur de portions de ce ruban, il est possible d'ajuster l'impédance d'entrée et de sortie du filtre.

## Revendications

1. Filtre réjecteur de bande à fréquence centrale de réjection unique, fonctionnant dans une gamme de fréquences allant de quelques mégahertz à quelques gigahertz et formé exclusivement d'une ou de plusieurs cellules de filtrage (110), chaque cellule étant composée exclusivement :

   - d'une première branche de circuit (130) comportant une première inductance (132, 332) et reliant une borne d'entrée (114, 314) de la cellule à une borne de sortie (116, 316) de la cellule, et
   - d'une deuxième branche de circuit comportant en série une deuxième inductance (142, 342) et une capacité (144, 344), cette deuxième branche étant connectée en parallèle sur la première inductance,

   la première inductance ayant une valeur $\ell$ inférieure à la valeur L de la deuxième inductance, les valeurs $\ell$ et L étant telles que $\frac{L}{100} \leq \ell \leq \frac{L}{10}$.

2. Filtre selon la revendication 1, **caractérisé en ce que** la première branche comporte des lignes à microruban conducteur (333, 335), disposées sur un substrat, et reliant respectivement la borne d'entrée (314) de la cellule à une première extrémité (334) de la première inductance et une deuxième extrémité (336) de la première inductance à la borne de sortie (316) de la cellule.

3. Filtre selon la revendication 2, **caractérisé en ce que** la première inductance est constituée par une portion (332) de microruban conducteur.

4. Filtre selon la revendication 2, **caractérisé en ce qu'**il comprend un microruban conducteur (332, 333, 335) formant la première branche de circuit et la première inductance qu'elle comporte.

5. Filtre selon la revendication 2, **caractérisé en ce que** les lignes à microruban présentent une largeur adaptée respectivement à une impédance d'entrée et à une impédance de sortie de la cellule.

6. Filtre selon la revendication 1, **caractérisé en ce qu'**il comporte une pluralité de cellules de filtrage reliées en chaîne.

## Claims

1. Band-rejection filter having a single central rejection frequency, operating in an operating range from a few megahertz to a few gigahertz and formed exclusively from one or more filtering cells (110), each cell being composed exclusively of:

   - a first circuit branch (130) comprising a first inductor (132, 332) and connecting an input terminal (114, 314) of the cell to an output terminal (116, 316) of the cell; and
   - a second circuit branch comprising, in series, a second inductor (142, 342) and a capacitor (144, 344), this second branch being connected in parallel to the first inductor;

   the first inductor having a value l of less than the value L of the second inductor, the values l and L being such that $\frac{L}{100} \leq l \leq \frac{L}{10}$.

2. Filter according to Claim 1, **characterized in that** the first branch comprises conducting microstrip lines (333, 335) placed on a substrate and connecting the input terminal (314) of the cell to a first end (334) of the first inductor and a second end (336) of the first inductor to the output terminal (316) of the cell, respectively.

3. Filter according to Claim 2, **characterized in that** the first inductor consists of a conducting microstrip portion (332).

4. Filter according to Claim 2, **characterized in that** it includes a conducting microstrip (332, 333, 335) forming the first circuit branch and the first inductor that the latter comprises.

5. Filter according to Claim 2, **characterized in that** the microstrip lines have a width tailored to an input impedance and to an output impedance of the cell, respectively.

6. Filter according to Claim 1, **characterized in that** it comprises a plurality of chain-linked filtering cells.

## Patentansprüche

1. Kerbfilter mit einer einzigen zentralen Sperrfrequenz, welcher in einem Frequenzbereich von einigen Megahertz bis zu einigen Gigahertz funktioniert und ausschließlich aus einer oder mehreren Filterzellen (110) gebildet ist, wobei jede Zelle ausschließlich zusammengesetzt ist aus:

   - einem ersten Schaltungszweig (130), welcher eine erste Induktivität (132, 332) umfasst und einen Eingangsanschluss (114, 314) der Zelle mit einem Ausgangsanschluss (116, 316) der Zelle verbindet, und
   - einem zweiten Schaltungszweig, welcher in Serie eine zweite Induktivität (142, 342) und eine Kapazität (144, 344) umfasst, wobei dieser zweite Schaltungszweig zu der ersten Induktivität parallel geschaltet ist,

wobei die erste Induktivität einen Wert l kleiner als der Wert L der zweiten Induktivität aufweist und die Werte l und L so sind, dass $\frac{L}{100} \leq l \leq \frac{L}{10}$ gilt.

2. Filter nach Anspruch 1, **dadurch gekennzeichnet, dass** der erste Zweig Leitungen in Form eines Mikroleitungsbandes (333, 335) umfasst, welche auf einem Substrat angeordnet sind und den Eingangsanschluss (314) der Zelle mit einem ersten Ende (334) der ersten Induktivität bzw. ein zweites Ende (336) der ersten Induktivität mit dem Ausgangsanschluss (316) der Zelle verbinden.

3. Filter nach Anspruch 2, **dadurch gekennzeichnet, dass** die erste Induktivität durch einen Abschnitt (332) des Mikroleitungsbandes gebildet ist.

4. Filter nach Anspruch 2, **dadurch gekennzeichnet, dass** er ein Mikroleitungsband (332, 333, 335) umfasst, welches den ersten Schaltungszweig und die darin enthaltene erste Induktivität bildet.

5. Filter nach Anspruch 2, **dadurch gekennzeichnet, dass** die Leitungen aus Mikroleitungsband eine Breite aufweisen, die an eine Eingangsimpedanz bzw. an eine Ausgangsimpedanz der Zelle angepasst ist.

6. Filter nach Anspruch 1, **dadurch gekennzeichnet, dass** er eine Mehrzahl von in einer Kette verbundenen Filterzellen umfasst.

FIG.1

FIG. 3

FIG. 2

FIG. 4

FIG. 6

FIG. 5